# EUROPÄISCHE PATENTSCHRIFT

(11) **EP 0 535 765 B1**
(45) Veröffentlichungstag und Bekanntmachung des Hinweises auf die Patenterteilung: **15.11.1995**
(21) Anmeldenummer: 92250213.3
(22) Anmeldetag: 11.08.1992
(51) Int. Cl.: H02H 5/10, G01R 31/02

(54) **Einrichtung zur Schutzleiterüberwachung**
Device for monitoring a neutral conductor
Dispositif pour la surveillance d'un conducteur neutre

(30) Priorität: 30.09.1991 DE 4133151
(43) Veröffentlichungstag der Anmeldung: 07.04.1993
(73) Patentinhaber: SIEMENS AKTIENGESELLSCHAFT, 80333 München (DE)
(72) Erfinder: Baumgärtl, Ulrich, W-1000 Berlin 20 (DE)

(56) Entgegenhaltungen:
- DE-A- 3 036 470

## Beschreibung

Die Erfindung betrifft eine Einrichtung zur Schutzleiterüberwachung von Zuleitungen ortsveränderlicher Betriebsmittel für Niederspannungsnetze im Bergbau unter Tage mit aus einem zustandsauswertenden Grundgerät und einem eine Meßspannung beeinflussendes Endglied, wobei das Endglied mit dem Grundgerät über einen Schutzleiter und über einen Überwachungsleiter mit entsprechendem Längswiderstand in Verbindung steht.

Die Überwachung von Schutzleitern auf ihre einwandfreie Funktion bis zum Verbraucher, wie sie insbesondere für Niederspannungsnetze im Bergbau unter Tage angewandt wird, ist aus der Produktschrift der Siemens AG "Universal-Niederspannungs-Überwachungssystem", Bestell-Nr. E271//2043 bekannt. Allgemeine Anforderungen und ein spezieller Überwachungsbaustein 8SG1150 sind auf den Seiten 5 und 9 hinreichend beschrieben, so daß lediglich auf das Meßprinzip im Zusammenhang mit der Leitungsproblematik eingegangen wird. Die Schutzleiterüberwachung erfolgt nach dem Meßverfahren des sogenannten Halbwellengleichstroms. Innerhalb des Überwachungsbausteins wird im Grundgerät an den Anschlußpunkten der Überwachungsleiter und dem Schutzleiter eine Wechselspannung angelegt, so daß bei fehlerfreiem Schutzleiter, der im Bereich des ortsveränderlichen Verbraucher durch die Reihenschaltung eines Widerstandes mit einem Gleichrichter im Endglied abgeschlossen ist, ein Halbwellengleichstrom fließt. Dieser Halbwellengleichstrom erzeugt innerhalb des Überwachungsbausteins an einem Meßwiderstand einen Spannungsabfall, der - geglättet durch eine parallel geschaltete RC-Kombination - mit einer fest vorgegebenen Vergleichsspannung verglichen wird. Ist der geglättete Spannungsabfall am Meßwiderstand größer als die feste Vergleichsspannung, so wird mittels einer Operationsverstärkereinrichtung ein entsprechendes Signalisierungsrelais angesteuert. Bei dieser Konstellation besteht zwischen dem Schutzleiter und dem Überwachungsleiter eine leitende Verbindung, so daß der Leitungsabschluß im Endglied durch Kurzschluß überbrückt ist. Die volle Halbwellenspannung liegt am Meßwiderstand.

Eine weitere Fehlermöglichkeit kann dadurch gegeben sein, daß der Schutzleiter, beispielsweise durch mechanische Einwirkung, unterbrochen ist. Am Meßwiderstand entsteht somit kein Spannungsabfall. Auch dieser Fall wird - wie bereits erwähnt - durch die Ansteuerung des Signalisierungsrelais mit erfaßt.

Dieses Meßprinzip arbeitet bis zu Kabellängen mit einer Kabelkapazität im Bereich um 4 µF zuverlässig, wobei die Fehlersignalisierung bei einem Kabellängswiderstand größer 1,6 kOhm und einem Querwiderstand zwischen dem Schutzleiter und dem Überwachungsleiter kleiner 1,6 kOhm erfolgt.
Die der Erfindung zugrunde liegende Aufgabe besteht darin, eine Einrichtung zur Schutzleiterüberwachung anzugeben, bei der die Einsatzmöglichkeit zur Schutzleiterüberwachung auch für längere Kabel mit Kabelkapazitäten größer 4 µF erreichbar ist, wobei jedoch die einschlägigen Vorschriften für Niederspannungsnetze im Bergbau unter Tage uneingeschränkt aufrechtzuerhalten sind.
Erfindungsgemäß wird dies dadurch erreicht, daß das Grundgerät zwischen dem Schutzleiter und dem mit einer Quellenspannung über einen Vorwiderstand verbundenen Überwachungsleiter vor dem Vorwiderstand einen Spannungsteiler mit einer ersten Teilspannung und nach dem Vorwiderstand einen Spannungsteiler mit einer zweiten Teilspannung aufweist, daß die erste Teilspannung einer über einen Leitungsbus mit einer Steuereinrichtung in Verbindung stehenden Analog-Digital-Wandlereinheit zuführbar ist, daß die zweite Teilspannung parallel einer Abtast-Halte-Einrichtung und einer Integriereinrichtung übertragbar ist, und daß zwischen dem Überwachungsleiter und dem Schutzleiter das Endglied derart dimensioniert ist, daß mit einer durch Erreichen einer Zenerdurchbruchspannung gesteuerten Schalteinrichtung die zweite Teilspannung einen sägezahnförmigen Verlauf annimmt.

Mit dem Einsatz der Gleichspannung als Quellenspannung und deren erfindungsgemäße Umwandlung in die miteinander zu vergleichenden Teilspannungen ist erreicht, daß die Leitungskapazität nicht mehr unmittelbar die Meßspannung bestimmt, sondern lediglich die Ladezeit bis zum Erreichen derselben beeinflußt. Die Meßspannung ist im wesentlichen abhängig vom Längs- und Isolationswiderstand des Kabels und der Größe der Zenerdurchbruchspannung.
Über den Vorwiderstand wird die Kabelkapazität und die Endglied-Kapazität aufgeladen. Erreicht die Spannung zwischen dem Schutzleiter und dem Überwachungsleiter die Spannungshöhe der Zündspannung vom Endglied, so wird die Schalteinrichtung leitfähig und entlädt die Kabelkapazität und die Endglied-Kapazität. Danach erfolgt erneut die Auflandung der Kabel- und Endglied-Kapazität, so daß die zweite Teilspannung einen sägezahnförmigen Verlauf annimmt. Mit dem jeweiligen Flankenwechsel nach Erreichen des höchsten und tiefsten Spannungswertes wird die Analog-Digital-Wandlereinrichtung entsprechend getriggert, und der gespeicherte Spannungswert von der Steuereinrichtung eingelesen. Zusätzlich kann in der Steuereinrichtung ein Zähler inkrementiert sein, so daß asynchron zum Meßvorgang ermittelt werden kann, ob in der Zwischenzeit erneut ein Meßwert vorliegt. Die innerhalb der Analog-Digital Wandlereinrichtung angeordneten Analogwertspeicher und Spannungskomperatoren sind zweikanalig aufgebaut, so daß die Spannungsmaxima und die Spannungsminima getrennt voneinander abgespeichert werden. Im ungestörten Leitungsfall tritt nur der Kanal für die positiven Spannungswerte (Spannungsmaxima) in Aktion. Aus den so gewonnenen Spannungswerten ist der Längswiderstand des Überwachungsleiters ständig errechenbar.

Liegt kein sägezahnförmiger Verlauf der Spannung mehr vor, so ist die Höhe der Gleichspannung am Überwachungsleiter maßgeblich für die Erkennung des vorliegenden Fehlers, da sich hieraus die Summe aus dem Längswiderstand und dem Isolationswiderstand errechnen läßt.
Daüber hinaus ist als wesentlich für die Erfindung anzusehen, daß auch fehlerhafte Zustände zwischen dem Überwachungsleiter und dem Niederspannungsnetz, repräsentiert durch den Fehler-Widerstand (RÜ), mit dieser Einrichtung erfaßbar sind. Bei dieser Fehlerart überlagert sich zu der sägezahnförmigen Teilspannung noch eine netzfrequente Sinusspannung, deren Höhe vom Verhältnis der Netzspannung zur Quellenspannung und dem Verhältnis des Isolationswiderstands zum Fehler-Widerstand abhängt. Die positive Halbwelle der Sinusspannung moduliert die Sägezahnfrequenz, so daß im Maximum der positiven Halbwelle auch ein Maximum der Sägezahnfrequenz auftritt. Die Negativhalbwelle dieser Sinusspannung verringert dagegen die Sägezahnfrequenz, so daß bei Niederohmigkeit zwischen dem Überwachungsleiter und dem Netzleiter die Sägezahnspannung völlig abbricht und lediglich eine negative Halbwelle als Meßspannung vorliegt.

Eine vorteilhafte Ausgestaltung der Erfindung sieht vor, daß die Quellenspannung 24 Volt-Gleichspannung beträgt und daß der Arbeitsbereich des Endglieds für Kabel mit einem Längswiderstand im Bereich kleiner 2,5 kOhm und einem Isolationswiderstand mit einem Wert größer 2,5 kOhm ausgelegt ist. Damit sind die im Bereich der Niederspannungsnetze auftretenden Gegebenheiten hinsichtlich der ordnungsgemäßen Schutzleiter-Überwachung in einfacher Weise zu realisieren.

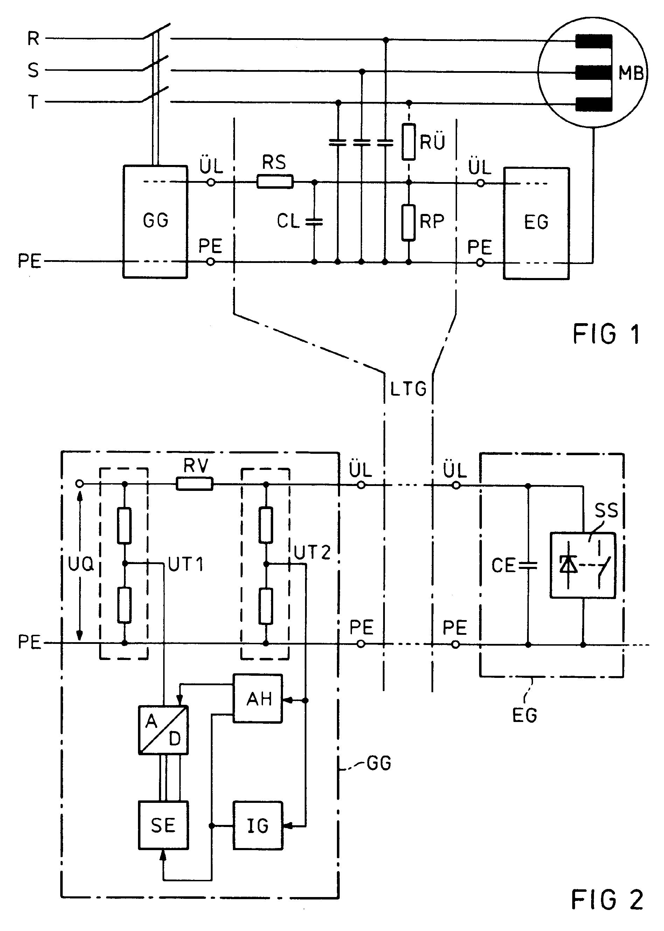

Die Erfindung wird durch einen Schaltungsauszug näher erläutert, wobei die Figur 1 ein sehr allgemeines Schaltschema mit den in der Praxis bestehenden Einflußgrößen von Kapazität C und Leitungs-Widerständen RS, RÜ darstellt, während der Figur 2 nähere Einzelheiten der erfindungsgemäßen Einrichtung zur Schutzleiterüberwachung zu entnehmen sind.

In der Figur 1 ist
das Niederspannungsnetz R, S, T dargestellt, welches über nicht bezeichnete Kontakte an ortsveränderliche Betriebsmittel MB anschaltbar ist. Innerhalb des Niederspannungsnetzes R, S, T sind der Überwachungsleiter ÜL und der Schutzleiter PE enthalten. Die Einrichtung zur Schutzleiterüberwachung ist im Prinzip durch das Grundgerät GG und das Endglied EG gebildet, zwischen denen sich die Leitungen LTG mit den sie beeinflussenden Größen der Kabelkapazität CL und des Längswiderstandes RS befinden. Durch den Fehler-Widerstand RÜ ist angedeutet, daß zwischen dem Niederspannungsnetz des Leiters T und dem Überwachungsleiter ÜL ein Kurzschluß besteht.

Die Figur 2 zeigt
weitere Einzelheiten des Grundgerätes GG, das über den Überwachungsleiter ÜL und den Schutzleiter PE direkt mit dem Endglied EG verbunden ist. Im Grundgerät GG ist angedeutet, daß hinter dem Vorwiderstand RV zwischen dem Überwachungsleiter ÜL und dem Schutzleiter PE die Quellenspannung UQ angeschaltet ist. Weiterhin ist angedeutet, daß durch Spannungsteiler vor und hinter dem Vorwiderstand RV eine erste Teilspannung UT1 und eine zweite Teilspannung UT2 gebildet wird, wobei die erste Teilspannung UT1 über die Analog-Digital-Wandlereinrichtung AD direkt der Steuereinrichtung SE zugeführt wird. Die zweite Teilspannung UT2 wird parallel einer Abtast-Halte-Einrichtung AH und einer Integriereinrichtung IG zugeführt. Mit Hilfe der Steuereinrichtung SE lassen sich die Betriebsparameter der Überwachungsleiter ÜL ermitteln und im Fehlerfall Abschaltungen der Betriebsmittel MB veranlassen.

Das Endglied EG enthält zwischen dem Überwachungsleiter ÜL und dem Schutzleiter PE die Endglied-Kapazität CE. Zwischen dem Übertragungsleiter ÜL und dem Schutzleiter PE ist außerdem die Schalteinrichtung SS geschaltet, die mit Hilfe einer Zehnerdurchbruchspannung den Ladestrom der Endglied-Kapazität CE durch annähernden Kurzschluß unterbricht. Durch diese taktweise Unterbrechung - nach jeder Unterschreitung der Zenerspannung sperrt die Schalteinrichtung SS diesen Stromweg -entsteht als zweite Teilspannung UT2 innerhalb des Grundgerätes GG eine Spannung mit sägezahnförmigen Verlauf. Entsprechend den Größenverhältnissen der Quellenspannung zu dieser Meßspannung kann mit Hilfe der Schalteinrichtung SE die tatsächliche Größe des Längswiderstandes RS ermittelt werden und im Fehlerfall entsprechende Maßnahmen zur zwangsweisen Abschaltung der Netzspannungsversorgung der ortsveränderlichen Betriebsmittel MB veranlaßt werden.

## Patentansprüche

1. Einrichtung zur Schutzleiterüberwachung von Zuleitungen ortsveränderlicher Betriebsmittel (MB) für Niederspannungsnetze im Bergbau unter Tage mit aus einem zustandsauswertenden Grundgerät (GG) und einem eine Meßspannung beeinflussendes Endglied (EG), wobei das Endglied mit dem Grundgerät über einen Schutzleiter (PE) und über einen Überwachungsleiter (ÜL) mit entsprechendem Längswiderstand in Verbindung steht,
**dadurch gekennzeichnet,** daß das Grundgerät (GG) zwischen dem Schutzleiter (PE) und dem mit einer Quellenspannung (UQ) über einen Vorwiderstand (RV) verbundenen Überwachungsleiter (ÜL) vor dem Vorwiderstand (RV) einen Spannungsteiler mit einer ersten Teilspannung (UT1) und nach dem Vorwiderstand (RV) einen Spannungsteiler mit einer zweiten Teilspannung (UT2) aufweist, daß die erste Teilspannung (UT1) einer über einen Leitungsbus mit einer Steuereinrichtung (SE) in Verbindung stehenden Analog-Digital-Wanlereinheit (AD) zuführbar ist, daß die zweite Teilspannung (UT2) parallel einer Abtast-Halte-Einrichtung (AH) und einer Integriereinrichtung (IG) übertragbar ist, und daß zwischen dem Überwachungsleiter (ÜL) und dem Schutzleiter (PE) das Endglied (EG) derart dimensioniert ist, daß mit einer durch Erreichen einer Zenerdurchbruchspannung gesteuerten Schalteinrichtung (SS) die zweite Teilspannung (UT2) einen sägezahnförmigen Verlauf annimmt.

2. Einrichtung zur Schutzleiterüberwachung nach Anspruch 1,
**dadurch gekennzeichnet**, daß die Quellenspannung (UQ) 24 Volt Gleichspannung beträgt und daß der Arbeitsbereich des Endglieds (EG) für Kabel mit einen Längswiderstand (RS) im Bereich kleiner 2,5 kOhm und einem Isolationswiderstand (RP) mit einem Wert größer 2,5 kOhm ausgelegt ist.

## Claims

1. Device for protective-conductor monitoring of supply leads of portable equipment (MB) for low-voltage systems in underground mining with a state-evaluating basic unit (GG) and a terminal element (EG) influencing a measuring voltage, whereby the terminal element is connected to the basic unit by way of a protective conductor (PE) and by way of a monitoring conductor (ÜL) with appropriate series resistance, characterized in that the basic unit (GG) between the protective conductor (PE) and the monitoring conductor (ÜL) connected to a source voltage (UQ) by way of an external resistance (RV) has in front of the external resistance (RV) a voltage divider with a first partial voltage (UT1) and after the external resistance (RV) a voltage divider with a second partial voltage (UT2), in that the first partial voltage (UT1) can be supplied to an analog-to-digital transformer unit (AD) connected by way of a conduction bus to a control device (SE), in that the second partial voltage (UT2) can be transmitted parallel to a sample-and-hold device (AH) and an integrating device (IG), and in that between the monitoring conductor (ÜL) and the protective conductor (PE) the terminal element (EG) is dimensioned in such a way that with a switching arrangement (SS), controlled by reaching a Zener breakdown voltage, the second partial voltage (UT2) assumes a saw-tooth characteristic.

2. Device for protective-conductor monitoring according to claim 1, characterized in that the source voltage (UQ) amounts to 24 volt direct voltage and in that the operating region of the terminal element (EG) is designed for cables with a series resistance (RS) in the region of less than 2.5 kOhm and an insulation resistance (RP) with a value greater than 2.5 kOhm.

## Revendications

1. Montage pour un dispositif de contrôle du conducteur neutre de lignes d'alimentation de moyens d'alimentation déplaçables (MB) pour des réseaux basse tension dans une exploitation minière souterraine, comportant un appareil de base (GG) évaluant un état, et un élément terminal (EG) qui influe sur une tension de mesure, l'élément terminal étant relié à l'appareil de base par l'intermédiaire d'un conducteur neutre (PE) et par l'intermédiaire d'un conducteur de contrôle (ÜL) comportant une résistance longitudinale correspondante,
caractérisé par le fait que l'appareil de base (GG) possède, entre le conducteur neutre (PE) et le conducteur de contrôle (ÜL), qui est relié à une tension de source (UK) par l'intermédiaire d'une résistance additionnelle (RV), et en amont de la résistance additionnelle (RV), un diviseur de tension possédant une première tension partielle (UT1) et, en aval de la résistance additionnelle (RV), un diviseur de tension possédant une seconde tension partielle (UT2), que la première tension partielle (UT1) peut être envoyée à une unité formant convertisseur analogique/numérique (AD), qui est reliée par l'intermédiaire d'un bus formant ligne à un dispositif de commande (SE), que la seconde tension partielle (UT2) peut être transmise en parallèle à un dispositif d'échantillonnage et de blocage (AH) et un dispositif intégrateur (IG), et qu'entre le conducteur de contrôle (ÜL) et le conducteur de protection (P1), l'élément terminal (EG) est dimensionné de telle sorte que la seconde tension partielle (UT2) prend une allure en forme de dents de scie au moyen d'un dispositif de commutation (SS) commandé lorsqu'une tension de claquage de Zener est atteinte.

2. Dispositif de contrôle de conducteur neutre suivant la revendication 1, caractérisé par le fait que la tension de source (U4) est une tension continue de 24 volts et que la gamme de travail de l'élément terminal (EG) pour le câble est réglée avec une résistance longitudinale (RS) dans la gamme inférieure à 2,5 k.ohms et une résistance d'isolement (RP) possédant une valeur supérieure à 2,5 k.ohms.
